(19) **Europäisches Patentamt / European Patent Office / Office européen des brevets**

(11) **EP 4 745 602 A1**

(12) **EUROPEAN PATENT APPLICATION**
published in accordance with Art. 153(4) EPC

(43) Date of publication:
20.05.2026 Bulletin 2026/21

(21) Application number: 24839259.9

(22) Date of filing: 02.04.2024

(51) International Patent Classification (IPC):
*G01R 31/392* (2019.01)  *G01R 31/367* (2019.01)
*G01R 31/374* (2019.01)  *G01R 31/3828* (2019.01)
*G01R 31/3842* (2019.01)  *G01R 31/387* (2019.01)
*G01R 31/389* (2019.01)  *H01M 10/48* (2006.01)
*H02J 7/00* (2026.01)

(52) Cooperative Patent Classification (CPC):
Y02E 60/10

(86) International application number:
PCT/JP2024/013642

(87) International publication number:
WO 2025/013361 (16.01.2025 Gazette 2025/03)

(84) Designated Contracting States:
AL AT BE BG CH CY CZ DE DK EE ES FI FR GB GR HR HU IE IS IT LI LT LU LV MC ME MK MT NL NO PL PT RO RS SE SI SK SM TR
Designated Extension States:
BA
Designated Validation States:
GE KH MA MD TN

(30) Priority: 10.07.2023 JP 2023113121

(71) Applicant: HITACHI HIGH-TECH CORPORATION
Tokyo 105-6409 (JP)

(72) Inventors:
• INOUE, Takeshi
  Tokyo 100-8280 (JP)
• KONISHI, Hiroaki
  Tokyo 100-8280 (JP)
• YONEMOTO, Masahiro
  Tokyo 105-6409 (JP)
• MOCHIZUKI, Masahito
  Tokyo 105-6409 (JP)
• SUMIKAWA, Yosuke
  Tokyo 105-6409 (JP)
• MAEDA, Junichi
  Tokyo 105-6409 (JP)
• HORIKOSHI, Nobuya
  Tokyo 105-6409 (JP)
• UEDA, Suguru
  Tokyo 100-8280 (JP)

(74) Representative: Strehl & Partner mbB
Maximilianstrasse 54
80538 München (DE)

(54) **METHOD FOR ESTIMATING LITHIUM-ION BATTERY DEGRADATION, AND LITHIUM-ION BATTERY DEGRADATION NOTIFICATION METHOD**

(57) To estimate resistance degradation and capacity degradation without using a correlation between resistance degradation and capacity degradation of a battery. A lithium-ion battery degradation estimation method includes the steps of: acquiring voltage time-series data, current time-series data, and temperature time-series data of a battery which is being charged; calculating resistance time-series data on the basis of the voltage time-series data and the current time-series data; correcting the resistance time-series data to resistance time-series data of predetermined temperature conversion on the basis of the temperature time-series data; calculating change amount time-series data from an initial value of a charge quantity on the basis of the current time-series data; generating as charge quantity versus resistance data, on the basis of the change amount time-series data and the corrected resistance time-series data; and enlarging or reducing the charge quantity versus resistance data in a vertical axis direction or a horizontal axis direction or shifting the data in the horizontal axis direction, estimating a resistance degradation rate on the basis of magnification in the vertical axis direction, and estimating a capacity degradation rate on the basis of magnification in the horizontal axis direction.

# FIG. 1

**Description**

Technical Field

The present invention relates to a lithium-ion battery degradation estimation method and a lithium-ion battery degradation notification method.

Background Art

In an EV (Electric Vehicle), generally, with years, a battery capacity decreases, and a cruising distance becomes shorter, so that a battery change becomes necessary. Batteries used for EVs can be roughly divided into a ternary lithium-ion battery of NMC, an LFP lithium-ion battery, and an LTO lithium-ion battery. As for the LFP lithium-ion battery, it is difficult to diagnose degradation of the battery. The reason is that, although a battery has a correlation between a charging rate and an electromotive force of the battery, in a lithium-ion battery, this correlation appears only in a full charge state and in an almost empty state of the battery. Consequently, in a battery degradation diagnosis, there is a method of using the correlation between resistance degradation and capacity degradation in the battery.

Such a method is described in, for example, Patent Literature 1. Concretely, it is described in the paragraph 0003 of the literature that "a correlation between internal resistance degradation and capacitance degradation of a battery is obtained in advance, and the correlation is stored as a table. The capacity degradation of the battery is calculated by using internal resistance degradation obtained from charge/discharge data at the time of travel and the correlation table".

Citation List

Patent Literature

PTL 1: Japanese Unexamined Patent Application Publication No. 2002-243813

Summary of Invention

Technical Problem

However, the correlation between resistance degradation and capacity degradation of a battery varies depending on individual differences of the batteries and degradation modes of the batteries (whether cycle degradation is dominant or storage degradation is dominant). Due to this, an error is large.

In consideration of the above, an object of the present invention is to provide a lithium-ion battery degradation estimation method of estimating resistance degradation and capacity degradation without using a correlation between resistance degradation and capacity degradation of a battery, and a lithium-ion battery degradation notification method.

Solution to Problem

In order to solve the above problems, a lithium-ion battery degradation estimation method according to the present invention includes: for example, an acquisition step of acquiring voltage time-series data, current time-series data, and temperature time-series data of a battery which is being charged; a calculation step of calculating resistance time-series data on the basis of the voltage time-series data and the current time-series data; a temperature correction step of correcting the resistance time-series data to resistance time-series data of predetermined temperature conversion on the basis of the temperature time-series data; a change amount calculation step of calculating change amount time-series data from an initial value of a charge quantity on the basis of the current time-series data; a time-series change generation step of generating, as charge quantity versus resistance data, a time-series change on a two-dimensional plane whose vertical axis denotes resistance and whose horizontal axis denotes a charge quantity on the basis of the change amount time-series data and the corrected resistance time-series data; and a matching step of enlarging or reducing the charge quantity versus resistance data in a vertical axis direction or a horizontal axis direction or shifting the data in the horizontal axis direction so as to be matched to standard charge resistance data, estimating a resistance degradation rate on the basis of magnification in the vertical axis direction, and estimating a capacity degradation rate on the basis of magnification in the horizontal axis direction.

In the lithium-ion battery degradation notification method according to the present invention, based on the degradation of the capacity of a battery estimated by the lithium-ion battery degradation estimation method, a message is generated and notified to the user.

Advantageous Effects of Invention

According to the present invention, it is possible to provide a lithium-ion battery degradation estimation method of estimating resistance degradation and capacity degradation without using a correlation between resistance degradation and capacity degradation of a battery, and a lithium-ion battery degradation notification method.

Objects, configurations, and effects other than the above will be apparent from the description of the following embodiments.

Brief Description of Drawings

   FIG. 1 is a diagram illustrating a schematic configuration example of a system.
   FIG. 2 is a diagram illustrating a configuration example of a battery pack.
   FIG. 3 is a diagram illustrating an example of charge quantity versus resistance data based on thinned data.
   FIG. 4 is a diagram for explaining matching in a first embodiment.
   FIG. 5 is a diagram illustrating an example of charge quantity versus voltage data.
   FIG. 6 is a diagram illustrating an example of SOC-OCV data.
   FIG. 7 is a diagram for explaining matching in a second embodiment.
   FIG. 8 is a diagram illustrating an example of a negative-electrode potential function.

Description of Embodiments

Embodiments of the present invention will be described below with reference to the drawings. In the diagrams, the same reference numeral is designated to the same configuration, and the detailed description of the overlapped part will be omitted.

First Embodiment

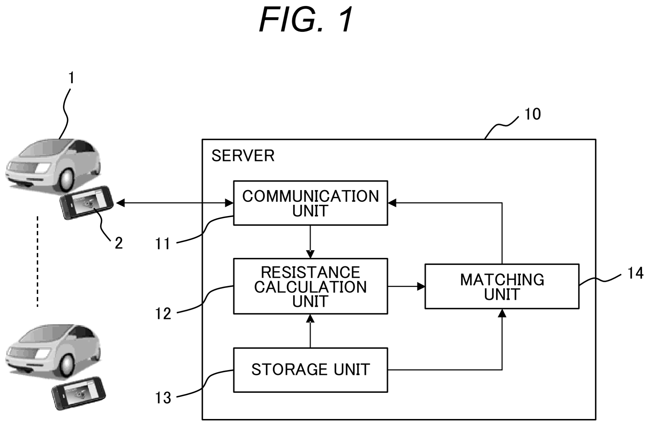

FIG. 1 is a diagram illustrating a schematic configuration example of a system. As illustrated in FIG. 1, each EV 1 sends battery data (time-series data of voltage of batteries in a battery pack, time-series data of current flowing in the battery pack, and time-series data of temperatures of some batteries) to a server 10 via a communication device 2.

The server 10 has a communication unit 11, a resistance calculation unit 12, a storage unit 13, and a matching unit 14. The server 10 calculates a resistance degradation rate and a capacity degradation rate of the battery pack on the basis of the received battery data. As necessary, battery energy capacity (Wh) may be calculated from the capacity degradation rate and the resistance degradation rate. Based on the calculation result, a message of necessity of battery change is transferred to an owner of the EV 1.

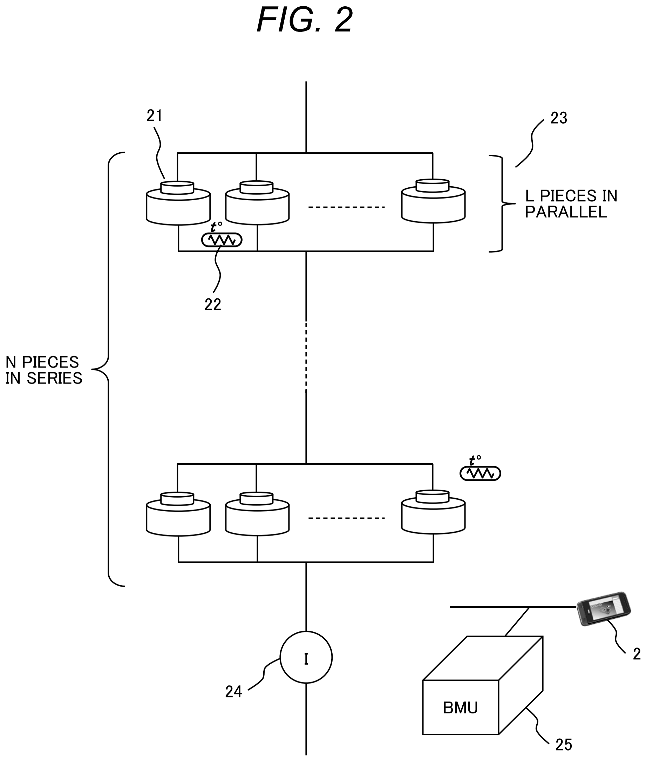

Subsequently, a configuration example of the battery pack in the EV 1 will be described with reference to FIG. 2. A battery cell 23 is obtained by connecting L pieces of batteries 21 in parallel, and the battery pack has a configuration in which N pieces of battery cells 23 are connected in series. The battery pack also has a thermistor (temperature sensor) 22, an ammeter 24, and a voltmeter (not illustrated). The battery pack has a BMU (Battery Management Unit) 25 managing the batteries by the voltage, current, and temperature obtained by the thermistor 22, the ammeter 24, and the voltmeter. The BMU 25 transmits the voltage, current, and temperature of the batteries to the communication device 2.

The principle of a lithium-ion battery degradation estimation method executed by the server 10 will now be described. The communication unit 11 receives battery data, to be specific, time series of voltages of the batteries in the battery pack, time series of currents flowing in the battery pack, and time series of temperatures of some of the batteries. As the battery data, data obtained by cutting data at the time of charging the EV 1 by a charger may be used or data obtained by cutting data during travel of the EV 1 may be used. The battery data in the charging of once is made by voltage time-series data $V_j(t)$ of a battery j, current time-series data $I(t)$, and temperature time-series data $Temp(t)$. Here, t denotes time. When there are a plurality of temperature sensors 22, IDs are allocated to the respective temperature sensors, and temperature time-series data measured by the temperature sensor 22 whose ID is k is expressed as $Temp_k(t)$. When there are a plurality of temperature sensors 22, it is also possible to set an average of temperatures measured by the temperature sensors 22 as $Temp(t)$.

When the battery 21 is left for a long time without charging/discharging, the voltage becomes a voltage according to a state of charge SOC. The voltage is expressed as OCV (SOC) as the function of the state of charge SOC. OCV (SOC) is preliminarily stored as SOC-OCV data in the storage unit 13.

Resistance time-series data $R_j(t)$ of the battery j is expressed by Expression (1). Therefore, by using Expression (1), the resistance time-series data $R_j(t)$ can be calculated on the basis of the voltage time-series data $V_j(t)$ and the current time-series data I(t) of the battery j.
Expression 1

$$Rj(t) = \{Vj(t) - OCV(SOCj(t))\}/I(t) \qquad (1)$$

Here, SOCj(t) in Expression (1) denotes the state of charge of the battery j at time t and is expressed by Expression (2) using SOCi(j) indicating the initial SOC of the battery j and Ah quantity Qmax(j) of the battery j as variables.
Expression 2

$$SOCj(t) = SOCi(j) + 100 \times \int I(t)dt \div Qmax(j) \qquad (2)$$

Therefore, in the case of using Expression (2) for Expression (1), the resistance time-series data Rj(t) of Expression (1) becomes a function including the two variables SOCi(j) and Qmax(j). $\int I(t)dt$ corresponds to a change amount from the initial value of the charge quantity of the battery j.

Here, resistance R(t;Temp) of one battery at temperature Temp is expressed by Expression (3) using resistance R25(t) at 25 °C in accordance with the Arrhenius law.
Expression (3)

$$R(t\,;Temp) = R25(t) \times exp\left[\frac{B}{(273.15 + Temp)} - \frac{B}{(273.15 + 25)}\right] \qquad (3)$$

B in Expression (3) is a constant and is called resistance temperature sensitivity. The resistance temperature sensitivity B is measured and set in advance and stored in the storage unit 13. As the value of the resistance temperature sensitivity B, for example, 2500[K] is used. When the temperature time-series data Temp(t) and Expression (3) are used for the resistance time-series data Rj(t) of Expression (1), 25 °C conversion resistance R25_j(t) is expressed by Expression (4).
Expression (4)

$$R25\_j(t) = \frac{Vj(t) - OCV(SOCj(t))}{I(t)exp\left[\frac{B}{(273.15 + Temp(t))} - \frac{B}{(273.15 + 25)}\right]} \qquad (4)$$

The resistance calculation unit 12 corrects the resistance time-series data Rj(t) to the resistance time-series data R25_j(t) of 25 °C conversion on the basis of the temperature time-series data Temp(t) and Expression (4). In this case, Qmax(j) and SOCi(j) are variables, and their values are not fixed.

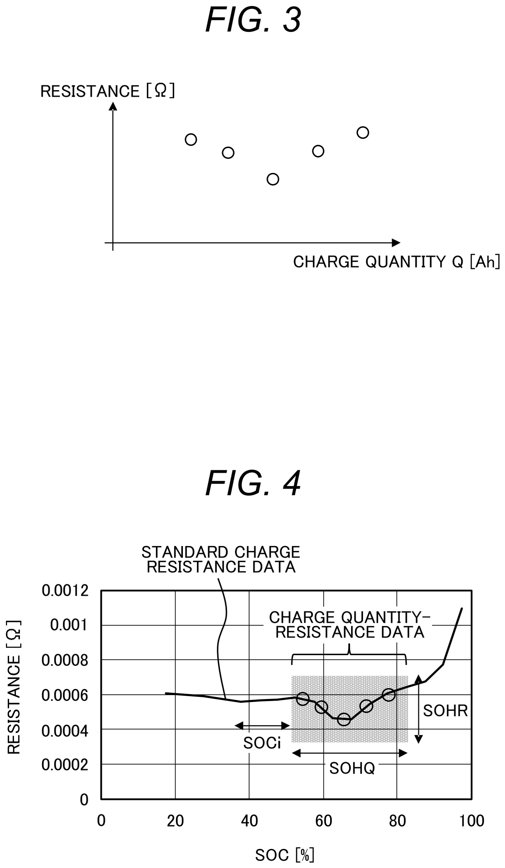

The resistance calculation unit 12 calculates change amount time-series data from the initial value of the charge quantity on the basis of the current time-series data I(t). This calculation is made by integrating the current time-series data I(t). On the basis of the change amount time-series data of the charge quantity and the resistance time-series data R25_j(t) of 25 °C conversion, a time-series change on a two-dimensional plane whose vertical axis is resistance and whose horizontal axis is charge quantity as charge quantity versus resistance data (refer to FIG. 3 which will be described later).

Subsequently, the matching unit 14 in FIG. 1 will be described. Standard charging resistance data of a new battery at 25°C is expressed as Rt_25(SOC). The 25 °C standard charging resistance data Rt_25 (SOC) is measured in advance and is preliminarily stored in the storage unit 13.

When degradation occurs, the resistance of 25 °C conversion of the battery j becomes a predetermined magnification of that of the 25°C standard charging resistance data Rt_25 (SOCj(t)) of a new battery regardless of the SOC. The magnification is set as the resistance degradation rate SOHR. When the battery degrades, the Ah capacity Qmax(j) also decreases.

The magnification of the Ah capacity Qmax(j) is set as the capacity degradation rate SOHQ. The relation of SOHQ = 100 × Qmax/catalog Qmax is satisfied. An index L(SOCi(j), Qmax(j), SOHR(j)) of matching is indicated by Expression (5).
Expression 5

$$L = \sum_{t=0}^{T} \left| R25\_j(t) - Rt\_25\big(SOCj(t)\big) \times SOHR(j)/100 \right|^{n} \qquad (5)$$

As n, 1 or 2 is used. As L, the maximum value of |R25_j(t)-Rt_25(soc(t))×SOHR(j)/100| may be used.

The matching unit 14 finds Qmax(j), SOHR(j), and SOCi(j) so that L becomes the minimum. As this method, a minimum value search algorithm such as the quasi-Newton's method is used. SOHQ(j) is calculated from the obtained Qmax(j), and SOHQ(j), SOHR(j), and SOCi(j) are output.

As the resistance time-series data R25_j(t) of 25 °C conversion, data at thinned N points may be used without using all of the data. FIG. 3 illustrates an example of charge quantity versus resistance data based on thinned data. In FIG. 3, the vertical axis indicates resistance, and the horizontal axis indicates charge quantity Q. As illustrated in FIG. 3, the resistance calculation unit 12 may generate the charge quantity versus resistance data by using a plurality of points, for example, five points in the resistance time-series data R25_j(t) of 25 °C conversion.

FIG. 4 is a diagram for explaining matching in the first embodiment. As illustrated in FIG. 4, the matching unit 14 adjusts the charge quantity versus resistance data so that the charge quantity versus resistance data matches the 25 °C standard charge resistance data Rt_25 (SOCj(t)). This is called matching. Concretely, the matching unit 14 performs the matching by shifting the charge quantity versus resistance data in the horizontal axis direction and enlarging or reducing the charge quantity versus resistance data in the vertical axis direction or the horizontal axis direction. Shifting of the charge quantity versus resistance data in the horizontal axis direction corresponds to adjustment of SOCi(j) which is as the initial SOC. Further, the magnification at the time of enlarging or reducing the charge quantity versus resistance data in the vertical axis direction corresponds to the resistance deterioration rate SOHR. The magnification at the time of enlarging or reducing the charge quantity versus resistance data in the horizontal axis direction corresponds to the capacity degradation rate SOHQ. Therefore, by matching the charge quantity versus resistance data to the 25 °C standard charging resistance Rt_25 (SOCj(t)), SOCi(j) as the initial SOC, the resistance degradation rate SOHR, and the capacity degradation rate SOHQ can be estimated.

The SOCi(j) as the initial SOC, the resistance degradation rate SOHR, and the capacity degradation rate SOHQ relate to the case of each cell. In the case of determining degradation on the battery pack unit basis, the ratio of new Ah capacities in a battery pack, the unbalance state (SOC of each cell when the battery pack is fully charged), and Wh capacity of the battery pack are necessary. As this method, the method described in International Publication No. 22/540225 may be used.

The communication unit 11 transmits the resistance degradation rate SOHR and the capacity degradation rate SOHQ which are estimated to the communication device.

When it is determined that the Wh capacity of the battery becomes, for example, 80% or 70% as compared with that of the battery which was new on the basis of the capacity degradation rate SOHQ obtained from the communication unit 11, the communication device 2 outputs a message "battery change required". A parameter used for determining degradation of a battery may not be the Wh capacity but may be an Ah capacity ratio in a battery pack. Further, the communication device 2 may grasp the trend of the Ah capacity or Wh capacity of a battery pack by plotting dates on the horizontal axis and the Ah capacity or Wh capacity of the battery pack on the vertical axis, predict a timing when the Ah capacity or Wh capacity reaches 70% or 80% of that of the battery pack which was new, and output "the end of the life of the battery is predicted as xx (month) in xx (year)". As described above, in the lithium-ion battery degradation notification method, based on degradation of the capacity of a battery estimated by the lithium-ion battery degradation estimation method, a message is generated and notified the message to the user.

According to the present invention, the method of estimating resistance degradation and capacity degradation can be provided without using the correlation between resistance degradation and capacity degradation of a battery.

Second Embodiment

Since a battery has a positive electrode and a negative electrode and degradation characteristic of the positive electrode and that of negative electrode are different, there is the possibility that the shape of a resistance table is deformed. Consequently, in a second embodiment, a method of capturing the characteristic of degradation of each of the positive electrode and the negative electrode will be described.

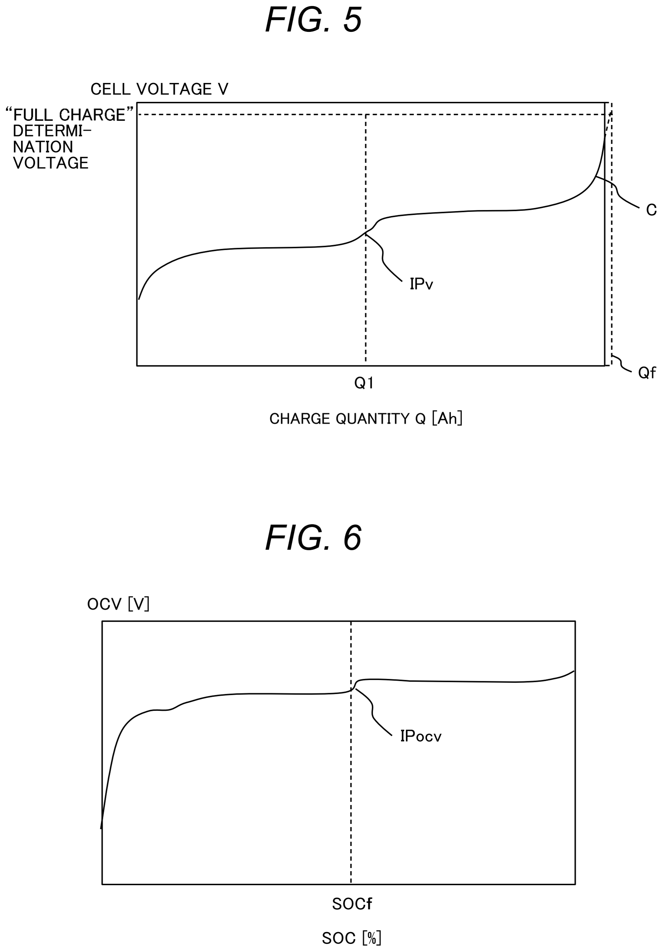

FIG. 5 is a diagram illustrating an example of charge quantity versus voltage data. FIG. 5 illustrates the case of charging a battery having an LFP positive electrode and a graphite negative electrode with constant current. Data illustrated in FIG. 5 is generated by the resistance calculation unit 12 by using, as charge quantity versus voltage data, a time-series change on a two-dimensional plane in which the vertical axis indicates cell voltage and the horizontal axis indicates the charge quantity Q[Ah] on the basis of the voltage time-series data Vj(t) and change amount time-series data from the initial value of the charge quantity. After start of charging, due to polarization of the battery, the cell voltage increases for a while. Then, the voltage becomes almost constant. However, due to a change in the potential of the negative electrode, an inflection point IPv appears. After that, the voltage becomes constant again and, then, increases around full charge (part C in FIG. 5). The part C is caused when the charge resistance of the positive electrode becomes large, and the potential of the positive electrode rises. Consequently, in the case where there is an inflection point and the cell voltage rapidly rises at the end of charging in charge quantity versus voltage data as illustrated in FIG. 5, the matching unit 14 performs matching for each of the positive electrode and the negative electrode. A case where charging is finished around full charge without performing charging to the full charge will be described.

FIG. 6 is a diagram illustrating an example of SOC-OCV data. In FIG. 6, the horizontal axis denotes SOC, the vertical axis indicates OCV, and the inflection point is expressed as IPocv. The value of SOC at the inflection point IPocv is almost fixed. In the embodiment, it is assumed that the SOC at the inflection point IPocv is 54%. The inflection point IPocv corresponds to the inflection point IPv of the charge quantity versus voltage data of FIG. 5. Consequently, when SOC at the inflection point IPv in FIG. 5 is set as SOCf, SOCf is 54%. The charge quantity at the inflection point IPv in FIG. 5 is set to Q1. Based on the SOC-OCV data, the value of SOCf is stored in the storage unit 13 in advance.

Then, a charge quantity Q2 from the charge quantity Q1 to a charge quantity Qf at the time of full charge is calculated (Q2 = Qf - Q1). Concretely, the cell voltage is extrapolated, the charge quantity Qf at the time of the full charge determination voltage (for example, 3.75V) is estimated, and the charge quantity Q2 is calculated.

As an extrapolation method, first, the resistance time-series data Rj(t) is obtained from the voltage time-series data Vj(t) and the current time-series data I(t) at the terminal stage of charging, and the time series is further converted to the 25 °C conversion resistance time-series data R25_j(t). Since OCV of the positive electrode becomes almost constant, for example, 3.4185V at the terminal stage of charging, the 25 °C conversion resistance time-series data R25_j(t) is expressed by Expression (6) derived by substituting 3.4185V in OCV in Expression (4).

Expression 6

$$R25\_j(t) = \frac{Vj(t) - 3.4185}{I(t)exp\left[\frac{B}{(273.15 + Temp(t))} - \frac{B}{(273.15 + 25)}\right]} \quad (6)$$

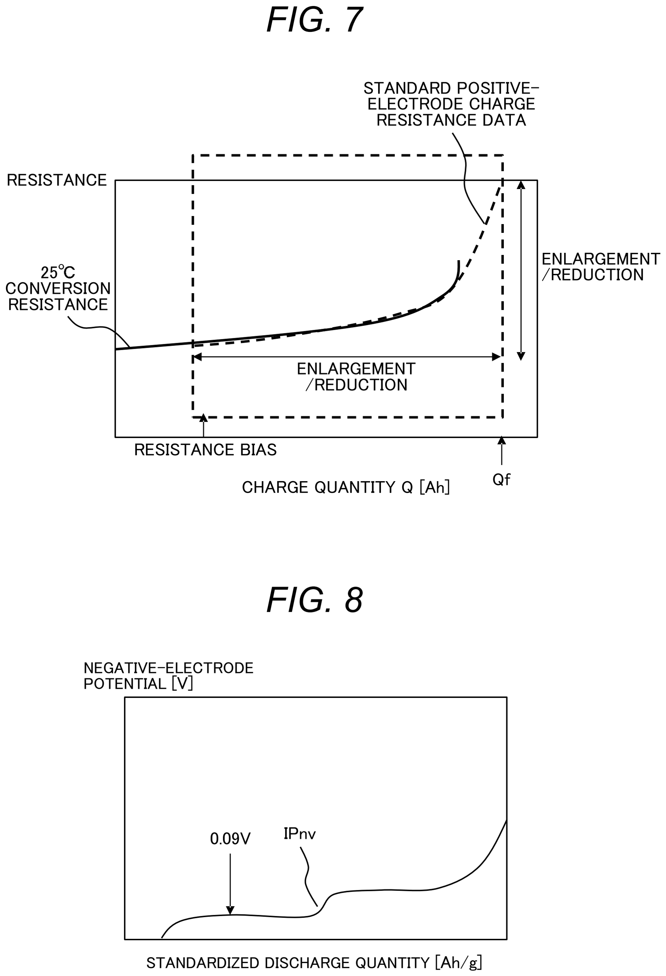

By using the calculated 25 °C conversion resistance time-series data R25_j(t), the charge quantity versus resistance data is created in a manner similar to the first embodiment. To the charge quantity versus resistance data, the standard positive electrode charging resistance data (the vertical axis: resistance, and the horizontal axis: SOC) is matched. FIG. 7 is a diagram for explaining matching in the second embodiment. The matching is performed by enlarging or reducing the standard positive electrode charging resistance data in the vertical axis direction or the horizontal axis direction and shifting the data in the vertical axis direction. The shift amount in the vertical axis direction will be called a resistance bias. The charge quantity at the resistance maximum value of the standard positive electrode charging data at the time of matching will be called charge quantity Qf of full charge. The Ah quantity Qmax of the battery is calculated as 100 × Q2 ÷ (100 - SOCf). As described above, the charge quantity Q2 is calculated by Qf - Q1. In a manner similar to the first embodiment, as the 25 °C conversion resistance time-series data R25_j(t), only a plurality of thinned points may be used without using all of the points.

Although the resistance R25_j(t) in Expression (6) includes the resistance of the negative electrode, since the resistance of the negative electrode becomes constant around the full charge, it is interpreted that the resistance of the negative electrode corresponds to the resistance bias. Further, it is assumed that data of the resistance R25_j(t) to be cut out is data that OCV exceeds 3.4185V in this example.

The enlargement/reduction ratio in the vertical axis direction is set as η, and the resistance bias is set as rb. η expresses resistance magnification of the positive electrode, and rb expresses the resistance of the negative electrode. If resistance rn at the high SOC when the negative electrode is new is known, SOHR may be expressed as 100 × rb/rn. The reason is that, when SOHR is set as an index of travel distance, the resistor on the discharge side is used and the resistance of the positive electrode on the discharge side becomes almost constant regardless of SOC, so that the resistance magnification of the negative electrode becomes important.

There is, however, the possibility that an error is large in this method. Consequently, it is also possible to perform matching by using neighborhood data as a second stage and, on assumption that this data expresses a characteristic of only the negative electrode, using standard charging resistance data of only the negative electrode. This method is operated in a manner similar to the matching in the first embodiment. SOCf is fixed in place of SOCi, and a bias amount (which is positive electrode resistance) in the vertical directions is added instead. The enlargement/reduction ratio in the vertical direction is SOHR.

There may be a case that the resistance magnification in the positive electrode and that in the negative electrode are different. In this case, the magnification of a resistance table in a certain SOC (SOC0, for example, SOC 50%) may be used. Concretely, SOHR may be obtained by using "standard negative electrode charge resistance (SOC0) $\times$ negative electrode magnification + positive electrode charge resistance (SOC0) $\times$ positive electrode magnification" as the present resistance and dividing the value by resistance in the initial SOC0.

Since a standard charge resistance table are of the positive and negative electrodes, the present charge resistance of the 25 °C conversion is obtained from the positive electrode magnification and the negative electrode magnification. Instead, when a discharge resistance table of the negative electrode is prepared, the discharge Wh capacity may be calculated by synthesizing the present discharge resistances of the positive and negative electrodes.

According to the embodiment, the resistance degradation in the positive electrode and that in the negative electrode can be obtained separately.

Third Embodiment

A positional deviation between the position of the positive electrode and the position of the negative electrode may be caused by degradation. By the positional deviation, the value of SOCf varies, and the shape of OCV changes. Handling to this case will be described.

In the example of the curve shape of OCV illustrated in FIG. 6, in the case where SOC is low, SOC can be estimated from OCV. Since full charge is determined when a certain cell reaches a full charge determination voltage (for example, 3.75V), the determination is easily performed. Consequently, SOCf and OCV are updated on the basis of data of the day when full charge is reached from low SOC. Although the shape of OCV changes at this time, in many cases, SOC is designed by fixing the value of OCV when SOC is 0%. Therefore, based on the value of OCV(0), the function of OCV is as indicated by Expression (7).

Expression 7

$$OCV(SOC) = Vp - Vn(bn - SOC \times an) \qquad (7)$$

Vp denotes the positive-electrode potential and may be fixed at 3.4185V in this case. Vn(x) denotes a resistance function in graphite. Here, x denotes[Ah/g] and is a potential function which is measured in advance. FIG. 8 illustrates an example of a negative electrode potential function Vn. Since OCV(0) is fixed, OCV(0) = Vp - Vn(bn) is satisfied. By this equation, the value of bn can be obtained and is an invariable value. Therefore, the parameter which is changed by degradation is "an". When x in the position of the inflection point IPnv is set to x2 (fixed value), the inflection point IPnv corresponds to the inflection point IPocv in FIG. 6, and SOC at the inflection point IPnv becomes SOCf, so that Expression (8) is satisfied.

Expression 8

$$bn - SOCf \times an = x2 \qquad (8)$$

Next, a method of obtaining SOCf will be described. The voltage just before start of charging is set as Vs. In this case, Vs = Vp - Vn (bn - SOCi $\times$ an) is satisfied (SOCi denotes the initial SOC). Therefore, Expression (9) is obtained.

Expression 9

$$bn - SOCi \times an = Vn^{-1}(Vp - Vs) \qquad (9)$$

$Vn^{-1}(x)$ is an inverse function of the function using data at high Ah/g in FIG. 8. The reason is that a value becomes almost constant at low Ah/g, and the inverse function is uncertain. Subsequently, the condition of Qmax is expressed as Expression (10).

Expression 10

$$Qmax = \frac{100 \times Qt}{100 - SOCi} = \frac{100 \times Q2}{100 - SOCf} \qquad (10)$$

Qt denotes a charge quantity Ah to reach full charge from the initial SOC. When the full charge is not yet achieved, Qt to the full charge is obtained by the method described in the second embodiment. Q2 denotes a charge Ah to reach full charge from the inflection point described in the second embodiment. From Expression (10), a relational expression of SOCf and SOCi is derived as (100-SOCi)/Qt=(100-SOCf)/Q2. From this expression, SOCi=100-(100-SOCf)Qt/Q2 is satisfied. When this expression is substituted in Expression (9), {bn- $Vn^{-1}$(Vp-Vs)} = SOCi $\times$ an ={100-(100-SOCf)Qt/Q2} $\times$ an is obtained. An expression obtained by substituting (bn- x2)/an=SOCf derived by deforming Expression (8) to the above expression is Expression (11). By solving Expression (11), "an" can be obtained.
Expression 11

$$bn - Vn^{-1}(Vp - Vs) = \left\{ 100 - \left( 100 - \frac{bn - x2}{an} \right) \times \frac{Qt}{Q2} \right\} \times an$$

$$= 100an - 100an \times \frac{Qt}{Q2} + (bn - x2) \times \frac{Qt}{Q2} \qquad (11)$$

Concretely, from Expression (11), an = [{bn-Vn$^{-1}$(Vp-Vs)} - (bn-x2)Qt/Q2] ÷ (100-100Qt/Q2) is derived. By using "an" for Expression (8), SOCf can be obtained. This SOCf is updated. Since an OCV function is determined from "an", the OCV function (SOC-OCV data) is updated.

Fourth Embodiment

In the first embodiment, the standard charge resistance table and the OCV at the time of 25 °C are necessary. This setting method will be described. As described in the third embodiment, in the case where full charge is reached from a low SOC, OCV can be set. Consequently, a battery which is new in the EV 1 is once made empty and then charged to full charge. In this case, not only SOCf, but also a cell voltage can be obtained.

Qmax is also derived. Consequently, the resistance at 25 °C can be obtained by Expression (4). Here, data (for example, 500 seconds) since start of charging until the polarization is abated may be ignored. In the case where the current changes in the middle, data for a while (for example, 500 seconds) since the current changes may be ignored.

It should be noted that the present invention is not limited to the embodiments described above, and includes various modification examples.

For example, the embodiments described above have been described in detail to simply describe the present invention, and are not necessarily required to include all the described configurations. Although examples of LFP and graphite have been described here, other materials may be used. Although an EV is assumed, the invention may be applied to a train, a construction machine, a forklift, or an agricultural machine driven by an EV. In addition, part of the configuration of one embodiment can be replaced with the configurations of other embodiments, and in addition, the configuration of one embodiment can also be added with the embodiments of other embodiments. In addition, part of the configuration of each of the embodiments can be subjected to addition, deletion, and replacement with respect to other configurations.

Reference Signs List

1:      EV
2:      communication device
10:    server
11:    communication unit
12:    resistance calculation unit
13:    storage unit
14:    matching unit
21:    battery
22:    temperature sensor
23:    battery cell
24:    ammeter
25:    BMU

**Claims**

**1.**  A lithium-ion battery degradation estimation method comprising:

an acquisition step of acquiring voltage time-series data, current time-series data, and temperature time-series data of a battery which is being charged;
a calculation step of calculating resistance time-series data on the basis of the voltage time-series data and the current time-series data;

a temperature correction step of correcting the resistance time-series data to resistance time-series data of predetermined temperature conversion on the basis of the temperature time-series data;

a change amount calculation step of calculating change amount time-series data from an initial value of a charge quantity on the basis of the current time-series data;

a time-series change generation step of generating, as charge quantity versus resistance data, a time-series change on a two-dimensional plane whose vertical axis denotes resistance and whose horizontal axis denotes a charge quantity on the basis of the change amount time-series data and the corrected resistance time-series data; and

a matching step of enlarging or reducing the charge quantity versus resistance data in a vertical axis direction or a horizontal axis direction, or shifting the data in the horizontal axis direction so as to be matched to standard charge resistance data, estimating a resistance degradation rate on the basis of magnification in the vertical axis direction, and estimating a capacity degradation rate on the basis of magnification in the horizontal axis direction.

2. A lithium-ion battery degradation estimation method comprising:

an acquisition step of acquiring voltage time-series data, current time-series data, and temperature time-series data of a battery which is being charged;

a resistance calculation step of calculating resistance time-series data on the basis of the voltage time-series data and the current time-series data;

a temperature correction step of correcting the resistance time-series data to resistance time-series data of predetermined temperature conversion on the basis of the temperature time-series data;

a change amount calculation step of calculating change amount time-series data of a charge quantity on the basis of the current time-series data;

a first data generation step of generating, as charge quantity versus resistance data, a time-series change on a two-dimensional plane whose vertical axis denotes resistance and whose horizontal axis denotes a charge quantity on the basis of the change amount time-series data of the charge quantity and the corrected resistance time-series data;

a second data generation step of generating, as charge quantity versus voltage data, a time-series change on a two-dimensional plane whose vertical axis denotes voltage and whose horizontal axis denotes a charge quantity on the basis of the voltage time-series data and the change amount time-series data of the charge quantity;

a charge quantity estimation step of adjusting standard positive electrode charge resistance data by enlarging, reducing or shifting the data in a vertical axis direction or a horizontal axis direction so as to be matched to the charge quantity versus resistance data, and estimating a charge quantity at a resistance maximum value of the adjusted standard positive electrode charge resistance data as a charge quantity of full charge; and

a capacity estimation step of estimating capacity of the battery by using a charge quantity at an inflection point in the charge quantity versus voltage data, a charge quantity of the full charge, and an SOC of an inflection point in SOC-OCV data which is prepared.

3. The lithium-ion battery degradation estimation method according to claim 2, further comprising:

a positive electrode resistance degradation estimation step of estimating a resistance degradation rate of a positive electrode on the basis of magnification in the vertical axis direction for the charge quantity versus resistance data of the adjusted standard positive electrode charge resistance data; and

a negative electrode resistance degradation estimation step of adjusting standard negative electrode charge resistance data by enlarging, reducing, or shifting the data in the vertical axis direction or the horizontal axis direction so as to be matched to the charge quantity versus resistance data, and estimating a resistance degradation rate of the negative electrode on the basis of the magnification in the vertical axis direction for the charge quantity versus resistance data of the adjusted standard negative electrode charge resistance data.

4. The lithium-ion battery degradation estimation method according to claim 2, further comprising:

an update step of, when charging is made from an empty state to full charge, calculating a magnification parameter of a negative electrode potential function on the basis of voltage just before start of charging, a prepared negative electrode potential function, a charge quantity at the inflection point, and a charge quantity at the full charge, calculating a SOC at the inflection point on the basis of the magnification parameter, and updating the SOC at the inflection point and the SOC-OCV data.

5. A lithium-ion battery degradation notification method of generating a message on the basis of degradation of capacity of the battery estimated by the lithium-ion battery degradation estimation method according to any of claims 1 to 4, and notifying the user of the message.

# FIG. 1

# FIG. 2

N PIECES
IN SERIES

L PIECES IN
PARALLEL

BMU

# FIG. 3

RESISTANCE [Ω]

CHARGE QUANTITY Q [Ah]

# FIG. 4

STANDARD CHARGE
RESISTANCE DATA

CHARGE QUANTITY–
RESISTANCE DATA

RESISTANCE [Ω]

0.0012
0.001
0.0008
0.0006
0.0004
0.0002
0

SOCi

SOHR

SOHQ

SOC [%]

0    20    40    60    80    100

## FIG. 5

CELL VOLTAGE V

"FULL CHARGE" DETERMI- NATION VOLTAGE

IPv

C

Qf

Q1

CHARGE QUANTITY Q [Ah]

## FIG. 6

OCV [V]

IPocv

SOCf

SOC [%]

# FIG. 7

RESISTANCE

STANDARD POSITIVE-
ELECTRODE CHARGE
RESISTANCE DATA

25℃
CONVERSION
RESISTANCE

ENLARGEMENT
/REDUCTION

ENLARGEMENT
/REDUCTION

RESISTANCE BIAS

Qf

CHARGE QUANTITY Q [Ah]

# FIG. 8

NEGATIVE-ELECTRODE
POTENTIAL [V]

0.09V

IPnv

STANDARDIZED DISCHARGE QUANTITY [Ah/g]

16

## INTERNATIONAL SEARCH REPORT

| International application No. |
|---|
| **PCT/JP2024/013642** |

**A. CLASSIFICATION OF SUBJECT MATTER**

*G01R 31/392*(2019.01)i; *G01R 31/367*(2019.01)i; *G01R 31/374*(2019.01)i; *G01R 31/3828*(2019.01)i; *G01R 31/3842*(2019.01)i; *G01R 31/387*(2019.01)i; *G01R 31/389*(2019.01)i; *H01M 10/48*(2006.01)i; *H02J 7/00*(2006.01)i
FI:  G01R31/392; G01R31/367; G01R31/374; G01R31/3828; G01R31/3842; G01R31/387; G01R31/389; H01M10/48 P; H01M10/48 301; H02J7/00 X; H02J7/00 Y

According to International Patent Classification (IPC) or to both national classification and IPC

**B. FIELDS SEARCHED**

Minimum documentation searched (classification system followed by classification symbols)

G01R31/36 - 31/396; H01M10/42 - 10/48; H02J7/00 - 7/12; 7/34 - 7/36

Documentation searched other than minimum documentation to the extent that such documents are included in the fields searched

Published examined utility model applications of Japan 1922-1996
Published unexamined utility model applications of Japan 1971-2024
Registered utility model specifications of Japan 1996-2024
Published registered utility model applications of Japan 1994-2024

Electronic data base consulted during the international search (name of data base and, where practicable, search terms used)

**C. DOCUMENTS CONSIDERED TO BE RELEVANT**

| Category* | Citation of document, with indication, where appropriate, of the relevant passages | Relevant to claim No. |
|---|---|---|
| A | JP 2023-028299 A (TOYOTA JIDOSHA KABUSHIKI KAISHA) 03 March 2023 (2023-03-03)<br>entire text, all drawings | 1-5 |
| A | JP 2023-077830 A (HITACHI, LTD.) 06 June 2023 (2023-06-06)<br>entire text, all drawings | 1-5 |
| A | JP 2014-149280 A (KABUSHIKI KAISHA TOSHIBA) 21 August 2014 (2014-08-21)<br>entire text, all drawings | 1-5 |
| A | JP 2002-050410 A (CANON KABUSHIKI KAISHA) 15 February 2002 (2002-02-15)<br>entire text, all drawings | 1-5 |
| A | JP 2010-249797 A (PRIMEARTH EV ENERGY CO., LTD.) 04 November 2010 (2010-11-04)<br>entire text, all drawings | 1-5 |

| ✓ Further documents are listed in the continuation of Box C. | ✓ See patent family annex. |
|---|---|

| | |
|---|---|
| * Special categories of cited documents:<br>"A" document defining the general state of the art which is not considered to be of particular relevance<br>"D" document cited by the applicant in the international application<br>"E" earlier application or patent but published on or after the international filing date<br>"L" document which may throw doubts on priority claim(s) or which is cited to establish the publication date of another citation or other special reason (as specified)<br>"O" document referring to an oral disclosure, use, exhibition or other means<br>"P" document published prior to the international filing date but later than the priority date claimed | "T" later document published after the international filing date or priority date and not in conflict with the application but cited to understand the principle or theory underlying the invention<br>"X" document of particular relevance; the claimed invention cannot be considered novel or cannot be considered to involve an inventive step when the document is taken alone<br>"Y" document of particular relevance; the claimed invention cannot be considered to involve an inventive step when the document is combined with one or more other such documents, such combination being obvious to a person skilled in the art<br>"&" document member of the same patent family |

| Date of the actual completion of the international search | Date of mailing of the international search report |
|---|---|
| **20 May 2024** | **04 June 2024** |

| Name and mailing address of the ISA/JP | Authorized officer |
|---|---|
| **Japan Patent Office (ISA/JP)**<br>**3-4-3 Kasumigaseki, Chiyoda-ku, Tokyo 100-8915**<br>**Japan** | |
| | Telephone No. |

Form PCT/ISA/210 (second sheet) (July 2022)

**INTERNATIONAL SEARCH REPORT**

| International application No. |
| PCT/JP2024/013642 |

**C.      DOCUMENTS CONSIDERED TO BE RELEVANT**

| Category* | Citation of document, with indication, where appropriate, of the relevant passages | Relevant to claim No. |
|---|---|---|
| A | JP 2017-219404 A (HITACHI CHEMICAL COMPANY, LTD.) 14 December 2017 (2017-12-14)<br>        entire text, all drawings | 1-5 |
| A | JP 2020-119658 A (HITACHI, LTD.) 06 August 2020 (2020-08-06)<br>        entire text, all drawings | 1-5 |
| P, A | JP 2023-140942 A (HITACHI, LTD.) 05 October 2023 (2023-10-05)<br>        entire text, all drawings | 1-5 |

Form PCT/ISA/210 (second sheet) (July 2022)

**INTERNATIONAL SEARCH REPORT**
Information on patent family members

International application No.

**PCT/JP2024/013642**

| Patent document cited in search report | | | Publication date (day/month/year) | Patent family member(s) | | | Publication date (day/month/year) |
|---|---|---|---|---|---|---|---|
| JP | 2023-028299 | A | 03 March 2023 | (Family: none) | | | |
| JP | 2023-077830 | A | 06 June 2023 | WO | 2023/095500 | A1 | |
| JP | 2014-149280 | A | 21 August 2014 | US | 2014/0222358 | A1 | |
| | | | | entire text, all drawings | | | |
| | | | | EP | 2762908 | A1 | |
| JP | 2002-050410 | A | 15 February 2002 | US | 2002/0109506 | A1 | |
| | | | | entire text, all drawings | | | |
| | | | | EP | 1158306 | A2 | |
| | | | | KR | 10-2004-0014921 | A | |
| | | | | CN | 1340874 | A | |
| JP | 2010-249797 | A | 04 November 2010 | US | 2010/0247988 | A1 | |
| | | | | entire text, all drawings | | | |
| JP | 2017-219404 | A | 14 December 2017 | (Family: none) | | | |
| JP | 2020-119658 | A | 06 August 2020 | EP | 3916884 | A1 | |
| | | | | entire text, all drawings | | | |
| | | | | WO | 2020/152901 | A1 | |
| JP | 2023-140942 | A | 05 October 2023 | WO | 2023/181589 | A1 | |

Form PCT/ISA/210 (patent family annex) (July 2022)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2002243813 A

- WO 22540225 A